(19) Europäisches Patentamt
European Patent Office
Office européen des brevets

(11) Veröffentlichungsnummer: **0 224 161 B1**

# (12) EUROPÄISCHE PATENTSCHRIFT

(45) Veröffentlichungstag der Patentschrift: **03.06.92**

(51) Int. Cl.$^5$: **G03F 7/004**, G03F 7/105

(21) Anmeldenummer: **86115912.7**

(22) Anmeldetag: **17.11.86**

## (54) Positiv arbeitendes strahlungsempfindliches Gemisch.

(30) Priorität: **25.11.85 DE 3541534**

(43) Veröffentlichungstag der Anmeldung:
**03.06.87 Patentblatt 87/23**

(45) Bekanntmachung des Hinweises auf die Patenterteilung:
**03.06.92 Patentblatt 92/23**

(84) Benannte Vertragsstaaten:
**AT BE CH DE FR GB IT LI NL SE**

(56) Entgegenhaltungen:
**EP-A- 0 042 562**
**EP-A- 0 146 411**
**EP-A- 0 153 682**
**DE-A- 2 733 005**
**FR-A- 1 590 914**
**GB-A- 997 170**
**GB-A- 1 426 277**

**RESEARCH DISCLOSURE, Nr. 155, März 1977, Seiten 78-80; Zusammenfassung Nr. 15568, Industrial Opportunities LTD, Havant, Hampshire, GB; J.F. LANGFORD et al.: "Spectral sensitisation of photocrosslinkable compositions"**

(73) Patentinhaber: **HOECHST AKTIENGESELLSCHAFT**
**Postfach 80 03 20**
**W-6230 Frankfurt am Main 80(DE)**

(72) Erfinder: **Ruckert, Hans, Dr., Dipl.-Chem.**
**Erbsenacker 21**
**W-6200 Wiesbaden-Naurod(DE)**
Erfinder: **Knaul, Joachim, Dr., Dipl.-Chem.**
**Entenfang 11**
**W-3007 Gehrden 1(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Rank Xerox (UK) Business Services

**Beschreibung**

Die Erfindung betrifft ein positiv arbeitendes, d. h. durch Bestrahlung löslich werdendes, strahlungsempfindliches Gemisch, das als wesentliche Bestandteile

a) eine bei Bestrahlung eine starke Säure bildende Verbindung,
b) eine Verbindung mit mindestens einer durch Säure spaltbaren C-O-C-Bindung,
c) ein in Wasser unlösliches, in wäßrig-alkalischen Lösungen lösliches Bindemittel und
d) einen Farbstoff

enthält und zur Herstellung von Photoresists, elektronischen Bauelementen und Druckplatten sowie zum Formteilätzen geeignet ist. Gemische der genannten Zusammensetzung sind z. B. in den US-A 3 779 778; 4 101 323; 4 189 323; den DE-A 27 18 254; 29 28 636 und den EP-A 0 006 626; 0 006 627 und 0 022 571 beschrieben. Weitere Verbesserungen und Varianten sind Gegenstand der EP-A 0 042 562 und der DE-A 31 51 078.

Bei Belichtung dieser Materialien wird durch Photolyse der Verbindung a) Säure gebildet, die die Spaltung von C-O-C-Gruppen der Verbindung b) bewirkt, so daß im Ergebnis die belichteten Bereiche der lichtempfindlichen Schichten im Entwickler löslich werden. Die lichtempfindlichen Gemische können auch noch lösliche oder feinteilige dispergierbare Farbstoffe sowie je nach Anwendungszweck auch UV-Absorber enthalten. Als Farbstoffe haben sich die Triphenylmethanfarbstoffe, insbesondere in der Form ihrer Carbinolbasen, besonders bewährt, die einen deutlichen Bildkontrast nicht erst nach der Entwicklung, sondern schon nach der Belichtung zeigen.

Es ist bekannt, daß allgemein Triarylmethanfarbstoffe in bestimmten strahlungsempfindlichen Gemischen als Sensibilisatoren für den Absorptionsbereich von 550-820 nm eingesetzt werden. Die durch Zugabe ihrer Leuko- oder Carbinolbasen zu erzielende bessere Lichtempfindlichkeit der betreffenden strahlungsempfindlichen Gemische wird in den DE-C 26 08 082 (= US-A 4 218 247), 11 17 391 (= GB-A 944 126), 25 26 720 (= US-A 4 063 948), in den DE-A 28 17 428 (= US-A 4 252 880) und 32 40 935 sowie in der EP-A 0 102 745 für Farbstoffe beschrieben, die in die Triarylmethanklasse zählen,sich aber auch von substituierten Benzo[a]carbazolen ableiten können.

In der US-A 3 109 736 werden die Leukobasen von Triphenyl- oder Diphenylmethanfarbstoffen zur Sensibilisierung von lichtempfindlichen Gemischen zugesetzt. Es zeigte sich aber, daß derartige strahlungsempfindliche Gemische nicht lagerfähig sind, da die Leukobase schon im Dunkeln zum Farbstoff oxidiert wird, d. h. auch der Untergrund stark farbig wird.

Die Verwendung von Triphenylmethanfarbstoffen in den eingangs erwähnten positiv arbeitenden strahlungsempfindlichen Gemischen, im folgenden zumeist als säurespaltbare Systeme bezeichnet, werden in der EP-A 0 042 562 und in der DE-A 31 51 078 beschrieben. Auch in diesen Gemischen machen sich die in der US-A 3 109 736 beschriebenen Unzulänglichkeiten bei Verwendung von Triarylmethanfarbstoffen bemerkbar. Hinzu kommt aber noch, daß der Wunsch nach einem dauerhaften Bildkontrast nach der Belichtung nicht immer erfüllt ist. Außerdem zeigte sich, daß in flüssigen Gemischen, d. h. in Beschichtungslösungen und sogenannten Flüssigresists, teils abhängig von Art und Reinheit der verwendeten Lösemittel, die Farbkonstanz nicht ausreichend ist.

Neben Triarylmethanfarbstoffen können in lichtempfindlichen Gemischen allgemein auch Polymethinfarbstoffe, die der Klasse der Photofarbstoffe zugerechnet werden, eingesetzt werden und die in der photographischen Industrie technische Anwendung finden. Als Zusätze in photographischen Silberhalogenidemulsionen sowie zu anderen lichtempfindlichen Substanzen wie Zinkoxid, Titan(IV)oxid oder organischen Fotoleitern, die nur für das (ultra)violette Gebiet empfindlich sind, müssen diese Farbstoffe folgende Anforderungen erfüllen:

- Wenn sie als Sensibilisatoren eingesetzt werden, haben sie die Aufgabe, die spektrale Empfindlichkeit der nur im (ultra)violetten Gebiet empfindlichen Silberhalogenidemulsionen auch auf das sichtbare und ggf. infrarote Spektralgebiet auszudehnen.
- Wenn sie als Antihalofarbstoffe verwendet werden, üben sie die Funktion von Filterfarbstoffen aus, die zur Absorption von nicht erwünschten Wellenlängen, insbesondere im UV-Bereich, eingesetzt werden. Durch diese Eigenschaft wird gleichzeitig die durch die photographische Emulsion hervorgerufene Dispersion des Lichtes und eine dadurch bewirkte Reduzierung der Bildschärfe verhindert.

Das Prinzip des Zusetzens von Photofarbstoffen dieser Art zu positiv oder negativ arbeitenden reprographischen Gemischen ist bei einigen strahlungsempfindlichen Gemischen bekannt. In diesen Fällen geht es im wesentlichen um die Sensibilisierung des lichtempfindlichen Materials, auch im sichtbaren Spektralbereich. Für diese Systeme, die allerdings nicht den eingangs beschriebenen säurespaltbaren Systemen entsprechen, sind die Sensibilisierungsbereiche hinsichtlich ihrer Wellenlänge mit den Absorptionsbereichen der Photofarbstoffe identisch oder zumindest weitgehend übereinstimmend.

Bei Cyaninfarbstoffen liegt dieser Spektralbereich im allgemeinen in einem Bereich von 350 - 450 nm.

In der US-A 3 106 466 wird z. B. ein Kopiermaterial zur Herstellung von farbbildenden Materialien, Photoresists und Druckplatten auf der Basis von Halogenkohlenwasserstoffen vorgestellt, mit dem nach Zusatz von Cyaninfarbstoffen zwar hohe Bildschärfen erzielt werden können; die Gemische zeigen aber eine relative Lichtunempfindlichkeit. Es wird ausgeführt, daß Merocyaninfarbstoffe in diesen Fällen vorzuziehen seien.

Ein Sensibilisator, der sowohl Strukturmerkmale eines Cyaninfarbstoffes wie auch die eines Merocyaninfarbstoffes aufweist, wird in der WO 83/00752 am Beispiel eines elektrophotographischen Materials beschrieben. Der Sensibilisator soll eine gute Absorption im sichtbaren Bereich zeigen und eine hohe Lichtstabilität des belichteten Farbstoffs aufweisen.

In den DE-C 12 83 093 und 12 86 898 werden zur Sensibilisierung der lichtempfindlichen, hier aber farbbildenden Materialien auf der Basis von Halogenkohlenwasserstoffen und N-Vinylverbindungen dreikernige, basische Merocyaninfarbstoffe verwendet. Diese Gemische sollen eine hohe Lichtempfindlichkeit, eine intensive Färbung, eine hohe Bildschärfe und eine gute Stabilität aufweisen.

In der EP-A 110 165 wird ein positiv arbeitendes Gemisch zur Herstellung eines Flüssigresists auf der Basis eines alkalilöslichen Bindemittels und eines o-Chinondiazids vorgestellt, in dem durch Verwendung von Polymethinfarbstoffen, deren konjugiertes System durch Nitrone symmetrisch erweitert ist, der Absorptionsbereich der Mischung in einen Bereich unter 350 nm, d. h. in den kurzwelligeren Bereich, verschoben werden kann. Auch diese Farbstoffe bewirken einen hohen Bildschärfekontrast.

Weiterhin ist bekannt, durch Kombination mehrerer Farbstoffe sogenannte panchromatisch sensibilisierte Aufzeichnungsmaterialien zu erreichen, die eine Sensibilisierung über den gesamten Spektralbereich erlauben. Solche Systeme werden anhand von elektrophotographischen Materialien in den DE-A 28 17 428, 23 53 639 und in der EP-A 0 004 944 beschrieben.

In der DE-C 27 18 259 (= US-A 4 189 323) werden lichtempfindliche Gemische beschrieben, die halogenhaltige, unter Strahlung Säure freisetzende Verbindungen, z. B. Trichlormethyl-triazinderivate, eine Verbindung mit mindestens einer C-O-C-Bindung, die durch Säure gespalten werden kann, ein Bindemittel, als Lösungsmittel ein Keton und zur Erzielung von Farbumschlägen Triarylmethanfarbstoffe, z. B. Kristallviolett, enthalten. Die Beispiele 3 und 4 dieser Patentschrift zeigen, daß es auch möglich ist, als Farbstoffe einen einen benzokondensierten Heterocyclus enthaltenden Styrylfarbstoff oder einen unsymmetrischen Cyaninfarbstoff zu verwenden. Von einer Sensibilisierungswirkung wird hier nichts erwähnt.

Neben den genannten Farbstoffen können zur Sensibilisierung von lichtempfindlichen Gemischen auf der Basis von photopolymerisierbaren Verbindungen im Bereich 350-400 nm grundsätzlich auch Hemicyanine (DE-A 24 10 387), Oxadiazole (EP-A 0 188 766( sowie Hemioxonole oder Oxonole (EP-A 0 146 411, DE-A 33 19 991) in Frage kommen.

Ein strahlungsempfindliches Gemisch, das zu einer strahlungsempfindlichen Schicht mit erhöhter Flexibilität führt, ist in der EP-A 0 153 682 offenbart. Das Gemisch enthält neben einer unter Einwirkung aktinischer Strahlung eine starke Säure bildenden Verbindung und einer Verbindung mit mindestens einer Säurespaltbaren C-O-C-Bindung ein polymeres Bindemittel mit Alkylphenoleinheiten. Zusätzlich kann das Gemisch noch Farbstoffe, insbesondere Triphenylmethan-Farbstoffe, oder UV-Absorber enthalten. In dieser Schrift kommt jedoch nicht zum Ausdruck, daß vorteilhafte technische Effekte bei Verwendung bestimmter Farbstoffe, die nicht zur Klasse der TriphenylmethanFarbstoffe gehören, erzielt werden.

In der GB-A 997 170 wiederum wird ein lichtempfindliches Gemisch genannt, das eine unter Einwirkung von Licht Radikale freisetzende Organohalogen-Verbindung der allgemeinen Formel $R\text{-}CHal_3$, insbesondere das relativ leichtflüchtige $CBr_4$, und einen Cyaninfarbstoff enthält. Geeignete Cyanin-Farbstoffe können gemäß dieser Schrift sowohl symmetrisch als auch unsymmetrisch aufgebaut sein. Der Farbstoff sensibilisiert das Gemisch für sichtbares Licht, insbesondere solches am roten, langwelligen Ende des Spektrums des sichtbaren Lichts.

Ein lichtempfindliches Gemisch mit einem N-Vinylcarbazol als ethylenisch ungesättigter photopolymerisierbarer Verbindung und mindestens einem Halogenmethyl-s-triazin als Initiator ist in der DE-A 12 98 414 (= FR-A 1 590 914) beschrieben. Damit hergestellte Schichten können durch Zusatz geeigneter Sensibilisatoren in ihrer Lichtempfindlichkeit noch gesteigert werden. Konkret als Sensibilisator offenbart ist ein Merocyanin.

Ein negativ arbeitendes Aufzeichnungsmaterial mit einer lichtempfindlichen Schicht, die neben einem Polymer mit Einheiten, in denen Kohlenstoffatome vorkommen, an die jeweils 2 oder 3 Halogenatome gebunden sind, und mindestens einem Metallcarbonyl noch einen Sensibilisator enthält, ist in der Research Disclosure No. 155, S. 78-80 (1977) genannt. Monomethin-, Polymethin-, Merocyanin- und Xanthen-Farbstoffe sowie Pyrylium-, Thiapyrylium- und Selenapyrylium-Salze werden als geeignete Sensibilisatoren bezeichnet.

In der EP-A 0 146 411 werden positiv und negativ arbeitende lichtempfindliche Gemische beschrieben, die neben einem Oniumsalz und einem Bindemittel einen Protonenspender, wie z. B. ein o-Chinondiazid enthalten, wozu aber auch die Leukobasen von Farbstoffen zählen, die durch das sensibilisierte Oniumsalz zum Farbstoff oxidiert werden. In dieser Patentanmeldung wird sogar ausgeführt, daß Oniumsalze grundsätzlich alle geeignet seien, um im sichtbaren Bereich zu absorbieren bzw. zu sensibilisieren, weil eine Protonierung bzw. eine positive Ladung allgemein zu einer bathochromen Farbverschiebung führte.

Genannt werden Iodonium-, Sulfonium-, Bromonium-, Chloronium-, Phosphonium-, Sulfoxonium-, Oxysulfonium-, Selenonium-, Telluronium- und Arsoniumsalze, durch Quaternierung positiv geladene Cyaninfarbstoffe, aber auch anionische, d. h. negativ geladene Oxonolfarbstoffe sowie neutrale Merocyaninfarbstoffe.

Eine derartige, bisher übliche Verallgemeinerung, die es erlaubt, vom Absorptionsspektrum auf den Sensibilisierungsbereich eines Farbstoffs zu schließen, wird durch die DE-A 33 19 991 in Frage gestellt.

Die Offenlegungsschrift hat ein negativ arbeitendes lichtempfindliches Gemisch aus einem Diazoharz und ggf. einem Bindemittel zum Gegenstand, das mit Oxonolfarbstoffen im Bereich 350 - 450 nm sensibilisiert werden soll. Mit diesen Farbstoffen werden neben einer hohen Sensibilisierung eine ausreichende Absorption von Streustrahlung, die einen besseren Bildkontrast auch nach längerer Bestrahlung ermöglicht und eine größere Bildschärfe erreicht. Dagegen weisen die in dem Vergleichsbeispiel 1 dieser Offenlegungsschrift verwendeten Farbstoffe, z. B. Benzolazophenylamin, Chrysoidin MC-Kristall oder ein Hemioxonolfarbstoff, obwohl sie aufgrund ihrer Absorptionsspektren zur Sensibilisierung geeignet sein sollten, eine Empfindlichkeitsabnahme im lichtempfindlichen Gemisch bei allerdings gleicher Bildschärfe auf.

Es ist daher nach diesem Stand der Technik nicht ohne weiteres möglich, einen als Sensibilisator für spezielle lichtempfindliche Gemische geeigneten Farbstoff vorauszubestimmen.

Aufgabe der Erfindung war es daher, ein positiv arbeitendes strahlungsempfindliches Gemisch bereitzustellen, das als wesentliche Bestandteile

a) eine strahlungsempfindliche Verbindung, die bei Einwirkung von aktinischer Strahlung eine starke Säure bildet,

b) eine Verbindung mit mindestens einer durch Säure spaltbaren C-O-C-Bindung,

c) ein in Wasser unlösliches, in wäßrig-alkalischen Lösungen aber lösliches Bindemittel und

d) einen Polymethinfarbstoff

enthält.

Das erfindungsgemäße Gemisch ist dadurch gekennzeichnet, daß der Polymethinfarbstoff ein Hemioxonol- oder ein symmetrischer Cyaninfarbstoff ist.

Die Gemische bewirken eine höhere Lichtempfindlichkeit und einen höheren Bildkontrast nach der Belichtung, der auch im wesentlichen irreversibel ist. Außerdem bleibt die Anfärbung von Flüssigresists, d.h. von Beschichtungslösungen, die von Kunden teils erst Monate nach der Herstellung auf das zu bearbeitende Substrat aufgebracht werden, bei Verwendung solcher Farbstoffe weitgehend konstant, während in den Fotoresistlösungen auf der Basis der säurespaltbaren Systeme, die mit Triphenylmethanfarbstoffen angefärbt sind, diese Farbkonstanz bei weitem nicht erreicht wird.

Durch Vergleichsversuche konnte gezeigt werden, daß nicht allein das Absorptionsspektrum eines gewählten Farbstoffs den Grad der Sensibilisierung beeinflußt, sondern auch das Bindemittel. So ergibt z. B. ein Hemioxonolfarbstoff wie das Säureviolett 520 PINA ® in einem sauren Polyacrylat-Harz einen etwas schwächeren Bildkontrast als in einer Phenol-Formaldehyd-Harzschicht.

Ein erkennbarer Zusammenhang zwischen dem Absorptionsverhalten im farbgebenden, sichtbaren Spektralbereich und im lichtempfindlichen Bereich, der zu einer Empfindlichkeitssteigerung in den erfindungsgemäßen Schichten führen sollte, besteht deshalb nicht. Es wird vermutet, daß die erfindungsgemäß eingesetzten Farbstoffe in den vorliegenden lichtempfindlichen Systemen beständigere protonierte Zwischenstufen bilden, die die höhere Stabilität des Bildkontrastes bedingen.

Die Farbstoffe können einzeln oder als Mischungen eingesetzt werden, wobei der Gesamtgehalt des Farbstoffs oder der Mischung, bezogen auf das Gesamtgewicht nichtflüchtiger Bestandteile der lichtempfindlichen Mischung, bei 0,05 bis 1,0 Gew.-% liegt. In bevorzugten Ausführungsformen liegt der Gesamtanteil bei 0,1 bis 0,6 Gew.-%.

Als Hemioxonolfarbstoffe werden solche der allgemeinen Formel I

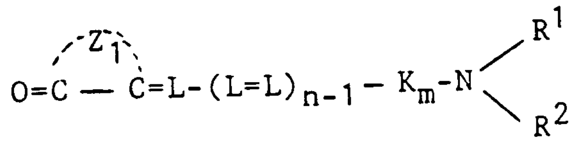

(I)

bevorzugt.

In dieser Formel können $R^1$ und $R^2$ sowohl Wasserstoffatome als auch Alkylgruppen sein, wobei eine symmetrische Substitution, d. h. $R^1 = R^2$, bevorzugt ist. Wenn Alkylgruppen gewählt werden, sind sie insbesondere kurzkettige, unverzweigte Gruppen, die vorzugsweise 1 bis 3 Kohlenstoffatome enthalten.

K bedeutet ein carbokonjugiertes Ringsystem. Hierfür können alle aromatischen Systeme in Frage kommen. Beispiele sind Benzol, Cyclopentadien oder 1- bis 3-kernige, kondensierte aromatische Ringsysteme, wie Naphthalin, Phenanthren sowie Mischkondensate aus Benzol und Cyclopentadien, wie z.B. Inden und Fluoren.

In den bevorzugten Ausführungsformen werden jedoch aromatische Systeme gewählt, die einen Benzolring als Grundkörper tragen.

m ist 0 oder 1, bevorzugt 1.

L bedeutet eine Methingruppe. Sie kann unsubstituiert oder durch kurze, zumeist unverzweigte Alkylgruppen substituiert sein, wobei die Substitution insbesondere in meso-Stellung, d. h. am mittleren Kohlenstoffatom der Polymethinkette, erfolgt; n ist eine positive Zahl von 1 bis 3, vorzugsweise 1 oder 2.

$Z_1$ steht für nichtmetallische Atome, die einen fünf-oder sechsgliedrigen heterocyclischen Ring komplettieren, der auch substituiert sein kann.

Es können 5-Ring- oder 6-Ring-Heterocyclen Anwendung finden, die zumeist in der zur Carbonylgruppe benachbarten Stellung ein Stickstoffatom als Ringglied tragen, so daß ein cyclisches Säureamid als ein allen Ringsystemen gemeinsames Strukturmerkmal entsteht.

Als 5-Ring-Heterocyclen können in Frage kommen (nach: L. Berlin und O. Riester, Cyanine, in: Houben-Weyl, Methoden der Org. Chemie, Bd. V/1d, 4. Auflage, Stuttgart 1972):

Thiazolidinone, wie z. B. 2,4-Dioxo-tetrahydro-1,3-thiazole, 4-Oxo-2-thioxo-tetrahydro-1,3-thiazole, insbesondere 3-(1-Benzo-thiazolyl)-4-oxo-2-thioxo-tetrahydro-1,3-thiazol, wobei die 3-Alkyl- bzw. 3-Arylderivate eingeschlossen sind.

Thiazolinone, wie z. B. 4-Oxo-dihydro-1,3-thiazoline, einschließlich der 2-Alkyl- oder 2-Aryl-Derivate sowie der 2-Dialkylamino-, 2-Diarylamino- oder der 2-Alkylarylamino-Derivate.

Oxazolidinone, wie z. B. 2,4-Dioxo-tetrahydro-1,3-oxazole, 4-Oxo-2-thioxo-tetrahydro-1,3-oxazole, einschließlich der 3-Alkyl- und 3-Arylabkömmlinge sowie 2-Imino-4-oxo-tetrahydro-1,3-oxazole, einschließlich der 2- und/oder 3-Aryl-, -Alkyl- bzw. -Diaryl- oder -Dialkyl-Derivate.

Oxazolinone, wie z. B. 4-Oxo-dihydro-1,3-oxazoline, einschließlich der 2-Alkyl- und 2-Aryl-Derivate.

Imidazolidinone, wie z. B. 2,4-Dioxo-tetrahydro-1,3-imidazole oder 4-Oxo-2-thioxo-tetrahydro-1,3-imidazole, einschließlich der 1-oder 3-Alkyl- und -Aryl-Derivate sowie der 1,3-Dialkyl-, -Diaryl- und -Arylalkyl-Derivate.

Selenazolidinone, wie z. B. 2,4-Dioxo-tetrahydro-1,3-selenazole, 4-Oxo-2-thioxo-tetrahydro-1,3-selenazole, einschließlich der Derivate (vgl. Thiazolidinone).

Pyrazolinone, wie z. B. 5-Oxo-dihydro-pyrazole, einschließlich der 1- oder 3-Alkyl- bzw. -Aryl- oder der 1,3-Dialkyl-, -Diaryl- oder -Alkylaryl-Derivate, die auch substituiert sein können. Als Substituenten kommen Carboxy-oder Sulfonsäuregruppen in Frage, die auch kernständig sein können.

Als 6-Ring-Heterocyclen können in Frage kommen:

Pyrimidinone, wie z. B. 2,4,6-Trioxopyrimidin (Barbitursäure) oder 4,6-Dioxo-2-thioxopyrimidin, einschließlich der 1- oder 3-Alkyl- bzw. -Aryl- oder der 1,3-Dialkyl-, -Diaryl- oder -Alkylaryl-Derivate (vgl. Pyrazolinone).

Piperazinone, wie z. B. 2,5-Dioxo-piperazine oder 5-Oxo-2-thioxo-piperazine, einschließlich der 1- oder 3-Alkyl- bzw. -Aryl- oder der 1,3-Dialkyl-, -Diaryl-oder -Alkylaryl-Derivate.

Besonders bevorzugt werden Hemioxonolfarbstoffe, die als Heterocyclus einen Pyrazolinonring tragen. Darunter fallen auch die Antihalofarbstoffe des PINA®-Sortiments der Riedel-de Haen AG, z. B. Säureviolett 520 PINA®, Art. Nr. 28 587, Säureviolett 520 A PINA®, Art. Nr. 28 582, Säureviolett 520 N PINA®, Art. Nr. 28 500, Säureviolett 520 T PINA®, Art. Nr. 28 579, Säureviolett 596 PINA®, Art. Nr. 28513 sowie das Säurerot 496 PINA®, Art. Nr. 28 591.

Darstellungsmethoden für Hemioxonolfarbstoffe werden in den US-A 2 089 729; 2 165 339, 2 186 608 und 2 216 441 beschrieben. R.C. Elderfield, in: The Chemistry of Heterocyclic Compounds, Vol. 5, S. 125-126, John Wiley & Sons, New York, London 1957, legt die Kondensationsreaktion von Pyrazolinonderivaten mit (vinylogen) Aldehyden, die der Synthese von Hemioxonolfarbstoffen der allgemeinen Formel I zugrunde liegt, dar.

Neben Hemioxonolfarbstoffen erfüllen auch mit Vorteil symmetrische Cyaninfarbstoffe der allgemeinen Formel II die Bedingungen, die die Aufgabenstellung enthält.

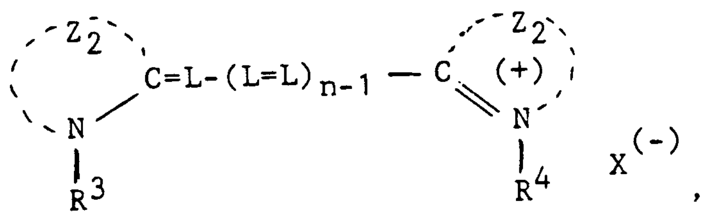

(II)

In dieser Formel bedeuten:

| | |
|---|---|
| L | eine Methingruppe, die unsubstituiert oder durch eine Alkylgruppe substituiert ist, |
| n | eine positive ganze Zahl von 1 bis 4, |
| $R^3$ und $R^4$ | jeweils einen Alkylrest, |
| $Z_2$ | die zur Vervollständigung eines ggf. substituierten heterocyclischen Ringsystems erforderlichen Atome und |
| $X^{(-)}$ | ein Anion. |

Die Quaternierung, d. h. das Entstehen einer positiven Ladung, wird durch Umsetzung der Basen mit bekannten Alkylierungsmitteln erreicht. Das Anion $X^-$ als einwertiger Säurerest ist daher durch die Wahl des Alkylierungsreagenzes vorausbestimmt. Es hat unter anderem hauptsächlichen Einfluß auf die Löslichkeit des Farbstoffs.

Die Löslichkeit nimmt dabei in der Reihenfolge Fluorid, Chlorid, Methylsulfat, Bromid, Toluolsulfonat, Rhodanid, Iodid, Perchlorat, Tetrafluoroborat, Pikrat, Phosphorwolframat ab. In den bevorzugten Ausführungsformen werden zur Quaternierung kurzkettige, unverzweigte Alkylbromide, insbesondere solche mit 1 bis 4 Kohlenstoffatomen, gewählt.

Das lineare, carbokonjugierte System $=L-(L=L)_{n-1}$-trägt, wenn es substituiert ist, vorzugsweise kurzkettige, unverzweigte Alkylgruppen, insbesondere in meso-Stellung. Als kurzkettige Alkylgruppen sind solche mit etwa 1 bis 4 Kohlenstoffatomen zu verstehen; n hat vorzugsweise den Wert 1 bis 3.

Als heterocyclische Ringsysteme $Z_2$ kommen prinzipiell alle Heterocyclen in Frage, die zumindest ein Stickstoffatom als Heteroatom tragen. Entsprechend der jeweiligen Heterocyclen unterscheidet man: Oxocarbocyanine, Imidocarbocyanine, Indocarbocyanine, Thiocarbocyanine, Selenocarbocyanine sowie Chinocarbocyanine. Als Heterocyclen sind dabei besonders hervorzuheben: Pyrrole, 1,3-Oxazole, Benzo-1 ,3-oxazole, 1,3-Thiazole, Benzo-1 ,3-thiazole, Naphtho[1,2-d]-1,3-thiazole, Naphtho[2,3-d]-1,3-thiazole, 1,3-Selenazole, Benzo-1,3-selenazole, Naphtho[1,2-d]1,3-selenazole, Naphtho[2,3-d]-1,3-selenazole, 1,3-Pyrazole, 1,2-Pyrazole, Indole, Benzo[c,d]indole, Benzimidazole, Thiazine, Oxazine, Pyridine, Pyrazine, Pyridazine, Pyrimidine, Triazine, Purine, Chinoline, Cinnoline, Phthalazine, Chinazoline, Chinoxaline sowie Pteridine.

Bevorzugt verwendet werden: Chinoline, 1,3-Thiazole, 1,3-Selenazole, Benzo-1,3-thiazole, Benzo-1,3-selenazole sowie die Naphtho[1,2-d]-1,3-thiazole und Naptho[2,3-d]-1,3-thiazole. Hierzu zählen auch die Photofarbstoffe des PINA-Sortiments der Riedelde Haen AG, Seelze, insbesondere die Sensibilisatoren S 935 PINA®, Art.-Nr. 28 246, KF 509 PINA®, Art.-Nr. 28 297 und KF 605 PINA®, Art.-Nr. 28 590.

Die Synthesemöglichkeiten für Cyaninfarbstoffe sind sehr vielfältig. Eine übersichtliche Zusammenfassung gibt F.M. Hamer, The Cyanine Dyes and Related Compounds in: The Chemistry of Heterocyclic Compounds, John Wiley & Sons, New York, London 1964.

Die erfindungsgemäßen Gemische enthalten ferner, wie oben erwähnt, eine strahlungs- bzw. lichtempfindliche Kombination von Verbindungen.

Zu den Komponenten, die beim Bestrahlen starke Säuren bilden bzw. abspalten, zählen eine große Anzahl von bekannten Verbindungen und Mischungen, wie Diazonium-, Phosphonium-, Sulfonium- und Iodonium-Salze, Halogen-Verbindungen, o-Chinondiazidsulfochloride und Organometall-Organohalogen-Kombinationen.

Die genannten Diazonium-, Phosphonium-, Sulfonium- und Iodonium-Verbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphosphor-, Hexafluorantimon- und -arsensäure.

Grundsätzlich sind als halogenhaltige strahlungsempfindliche und Halogenwasserstoffsäure bildende

Verbindungen alle auch als photochemische Radikalstarter bekannten organischen Halogenverbindungen, beispielsweise solche mit mehr als einem Halogenatom an einem Kohlenstoffatom oder an einem aromatischen Ring, brauchbar. Beispiele sind in den US-A 3 515 552, 3 536 489 und 3 779 778, der DE-C 26 10 842 und den DE-A 22 43 621, 27 18 259 und 33 37 024 beschrieben. Von diesen Verbindungen werden die s-Triazinderivate mit 2 Halogenmethylgruppen, insbesondere Trichlormethylgruppen, und einem aromatischen bzw. ungesättigten Substituenten im Triazinkern, wie sie in den DE-A 27 18 259 und 33 37 024 beschrieben sind, bevorzugt.

Beispiele für geeignete Starter sind: 4-(Di-n-propylamino)-benzoldiazoniumtetrafluoroborat, 4-p-Tolylmercapto-2,5-diethoxy-benzoldiazoniumhexafluorophosphat und -tetrafluoroborat, Diphenylamin-4-diazoniumsulfat, 4-Methyl-6-trichlormethyl-2-pyron, 4-(3,4,5-Trimethoxy-styryl)-6-trichlormethyl-2-pyron, 4-(4-Methoxy-styryl)-6-(3,3,3-trichlor-propenyl)-2-pyron, 2-Trichlormethylbenzimidazol, 2-Tribrommethyl-chinolin, 2,4-Dimethyl-1-tribromacetyl-benzol, 3-Nitro-1-tribromacetyl-benzol, 4-Dibromacetyl-benzoesäure, 1,4-Bis-dibrommethyl-benzol, Tris-dibrommethyl-s-triazin, 2-(6-Methoxy-naphth-2-yl)-, 2-(Naphth-1-yl)-, 2-(Naphth-2-yl)-, 2-(4-Ethoxy-ethyl-naphth-1-yl)-, 2-(Benzopyran-3-yl)-, 2-(4-Methoxy-anthrac-1-yl)-, 2-(4-Styryl-phenyl)-, 2-(Phenanthr-9-yl)-4,6-bis-trichlormethyl-s-triazin und die in den Beispielen angeführten Verbindungen.

Die Menge des Starters kann je nach seiner chemischen Natur und der Zusammensetzung des Gemischs ebenfalls sehr verschieden sein. Günstige Ergebnisse werden erhalten mit etwa 0,1 bis 10 Gew.-%, bezogen auf den Gesamtfeststoff, bevorzugt sind 0,2 bis 5 %. Besonders für Kopierschichten von Dicken über 10 µm empfiehlt es sich, relativ wenig Säurespender zu verwenden.

Als durch Säure spaltbare Verbindungen sind in erster Linie solche zu nennen, die mindestens eine Orthocarbonsäureester- und bzw. oder Carbonsäureamidacetalgruppierung tragen, wobei die Verbindungen auch polymeren Charakter haben und die genannten Gruppierungen als verknüpfende Elemente in der Hauptkette oder als seitenständige Substituenten auftreten können, ferner Oligomer- oder Polymerverbindungen mit wiederkehrenden Acetal- und/oder Ketalgruppierungen in der Hauptkette und Verbindungen mit mindestens einer Enolether- oder N-Acyliminocarbonatgruppierung.

Solche durch Säure spaltbaren Verbindungen sind in den US-A 3 779 778 und 4 101 323, den De-C 27 18 254 und 23 06 248, den DE-A 28 29 512 und 28 29 511 sowie in den EP-A 0 022 571, 0 006 626 und 0 006 627 beschrieben.

Von den in der US-A 4 101 323 beschriebenen Orthocarbonsäurederivaten werden besonders die Bis-1,3-dioxan-2-yl-ether von aliphatischen Diolen verwendet. Von den in der DE-C 27 18 254 beschriebenen Polyacetalen werden diejenigen mit aliphatischen Aldehyd- und Dioleinheiten bevorzugt.

Weitere gut geeignete Gemische sind in der DE-A 29 28 636 beschrieben. Dort werden als säurespaltbare Verbindungen polymere Orthoester mit wiederkehrenden Orthoestergruppen in der Hauptkette beschrieben. Diese Gruppen sind 2-Alkylether von 1,3-Dioxa-cycloalkanen mit 5 oder 6 Ringgliedern. Besonders bevorzugt werden Polymere mit wiederkehrenden 1,3-Dioxa-cyclohex-2-yl-alkylethereinheiten, in denen die Alkylethergruppe durch Ethersauerstoffatome unterbrochen sein kann und bevorzugt an die 5-Stellung des benachbarten Rings gebunden ist.

Der Mengenanteil der säurespaltbaren Verbindungen in dem lichtempfindlichen Gemisch liegt im allgemeinen zwischen 5 und 65, vorzugsweise zwischen 6 und 30 Gew.-%, bezogen auf die nichtflüchtigen Bestandteile des Gemischs.

Die Beschichtungslösungen können zusätzlich zu den vorstehend beschriebenen lichtempfindlichen Bestandteilen polymere Bindemittel enthalten. Dabei werden solche Polymeren bevorzugt, die wasserunlöslich und in wäßrig-alkalischen Lösungen löslich oder quellbar sind.

Als alkalilösliche bzw. in Alkali quellbare Bindemittel sind natürliche Harze wie Schellack und Kolophonium und synthetische Harze wie Mischpolymerisate aus Styrol und Maleinsäureanhydrid oder Mischpolymerisate der Acrylsäure oder Methacrylsäure, insbesondere mit Acryl- oder Methacrylsäureestern, sowie insbesondere Novolake zu nennen. Als Novolak-Kondensationsharze haben sich besonders die höher kondensierten Harze mit substituierten Phenolen als Formaldehyd-Kondensationspartner bewährt. Die Art und Menge der alkalilöslichen Harze kann je nach Anwendungszweck verschieden sein; bevorzugt sind Anteile am Gesamtfeststoff zwischen 30 und 90, besonders bevorzugt 55 - 85 Gew.-%. Statt oder im Gemisch mit Novolaken sind vorteilhaft auch Polymere vom Typ des Poly(alkenyl-phenols) oder von (Meth)-acrylsäureestern mehrwertiger Phenole verwendbar. Zusätzlich können noch zahlreiche andere Harze mitverwendet werden, bevorzugt Vinylpolymerisate wie Polyvinylacetate, Polyacrylate, Polyvinylether und Polyvinylpyrrolidone, die selbst durch Comonomere modifiziert sein können. Der günstigste Anteil an diesen Harzen richtet sich nach den anwendungstechnischen Erfordernissen und dem Einfluß auf die Entwicklungsbedingungen und beträgt im allgemeinen nicht mehr als 20% vom alkalilöslichen Harz. In geringen Mengen kann das lichtempfindliche Gemisch für spezielle Erfordernisse wie Flexibilität, Haftung und Glanz etc. außerdem noch Substanzen wie Polyglykole, Cellulosederivate wie Ethylcellulose und Netzmittel enthalten.

Die Photoresistlösung kann in üblicher Weise, z. B. durch Tauchen, Gießen, Schleudern, Sprühen, mittels Walzen oder durch Schlitzdüsen auf den zu beschichtenden Träger aufgebracht werden.

Als Träger, die mit den erfindungsgemäßen Lösungen beschichtet werden können, sind alle in der Photoresisttechnik gebräuchlichen Materialien geeignet, z. B. kupferkaschierte Isolierstoffplatten, Kupferzylinder für den Tiefdruck, Nickelzylinder für den Siebdruck, Aluminiumplatten, Glasplatten sowie die in der Mikroelektronik üblichen Silicium-, Siliciumnitrid- und Siliciumdioxidoberflächen. Auch Hoch- und Offsetdruckplatten können durch Aufbringen der erfindungsgemäßen Beschichtungslösungen, z. B. auf Zink-, Messing-Chrom-oder Aluminium-Kupfer-Chrom-, Aluminium- oder Stahlplatten, hergestellt werden.

Bevorzugte Träger für dicke Schichten über 10 µm sind Kunststoffolien, die dann als temporäre Träger für Transferschichten dienen. Dafür und für Farbfolien werden Polyesterfolien, z. B. aus Polyethylenterephthalat, bevorzugt. Polyolefinfolien wie Polypropylen sind jedoch ebenfalls geeignet. Als Schichtträger für Schichtdicken unter ca. 10 µm werden meist Metalle verwendet. Für Offsetdruckplatten können eingesetzt werden: mechanisch oder chemisch aufgerauhtes und gegebenenfalls anodisiertes Aluminium, das zudem noch chemisch, z. B. mit Polyvinylphosphonsäure, Silikaten oder Phosphaten, vorbehandelt sein kann.

Schließlich kann die Beschichtung direkt oder durch Schichtübertragung vom temporären Schichtträger erfolgen auf Leiterplatten-Materialien, die aus Isolierplatten mit ein- oder beidseitiger Kupferauflage bestehen, auf Glas oder Keramik-Materialien, die gegebenenfalls haftvermittelnd vorbehandelt sind, und auf Silicium-Scheiben. Außerdem können Holz, Textilien und Oberflächen vieler Werkstoffe beschichtet werden, die vorteilhaft durch Projektion bebildert werden und resistent gegen die Einwirkung alkalischer Entwickler sind.

Als Lösemittel werden z. B. Ethylenglykolmonomethylether, Ethylenglykolmonoethylether, aliphatische Ester, wie Butylacetat, aliphatische Ketone, wie Methylisobutylketon und Aceton, Dioxan, Xylol, halogenierte aromatische Verbindungen, wie chloriertes Xylol, Benzol und Toluol eingesetzt.

Hauptbestandteil der technischen Photoresistlösungen sind im allgemeinen Ethylenglykolderivate, wie die Monomethyl- und Monoethylether, die entsprechenden Ether des Diethylenglykols oder das Ethylenglykolethyletheracetat. Es können aber auch Mono-$C_1$ bis -$C_4$-alkylether des 1,2-Propandiols verwendet werden. Die Alkylethergruppe kann in der 1-Stellung oder der 2-Stellung des Propandiols stehen, im allgemeinen wird beim Monomethylether das leichter zugängliche 1-Methoxypropan-2-ol bevorzugt. Es können auch Gemische von beiden Methylisomeren und/oder Gemische der Mono-$C_1$ bis $C_4$-alkylether des Propandiols eingesetzt werden.

Die genannten handelsüblichen Propandiolether haben den Vorteil, daß sie in vielen Fällen einheitlicher verlaufende Beschichtungslösungen und gleichmäßigere Schichten ergeben. Die Vorteile im Verhalten der Lösung bleiben erhalten, wenn ein Teil des Propandiolmonoalkylethers durch andere übliche Zusatzlösemittel, wie Ester, z. B. Butylacetat, Kohlenwasserstoffe, z. B. Xylol, Ketone, z. B. Aceton oder Butanon, Alkohole oder bestimmte Alkoxyalkylester, z. B. 3-Methoxybutylacetat, ersetzt werden. Auf diese Weise ist es möglich, falls gewünscht, im Einzelfall das Benetzungs-, Fließ- und Verdunstungsverhalten der Lösung zu modifizieren. Der Mengenanteil an solchen zusätzlichen Lösemitteln sollte in jedem Fall unter 50 Gew.-% liegen. Bevorzugt beträgt der Anteil 0-35, insbesondere 0-20 Gew.-%, bezogen auf das Lösemittelgemisch. Dementsprechend besteht das erfindungsgemäße Lösemittel bzw. Lösemittelgemisch zu 65 bis 100 % aus einem 1,2-Propandiolmono-$C_1$ bis $C_4$-alkylether, vorzugsweise aus einem 1,2-Propandiolmonomethyl- und/oder -ethyl-ether. Es ist z. B. auch möglich, durch Zusatz höhersiedender Alkohole oder Ether, die beim Trocknen in geringer Menge (z. B. 1-2 %) in der Schicht zurückbleiben, die Flexibilität der Schicht zu erhöhen. Ebenso kann gewünschtenfalls die Verdunstungsgeschwindigkeit durch Zusatz eines niedriger siedenden Lösemittels, z. B. sec.Butanol, erhöht werden.

Für die Trocknung nach der Beschichtung können die üblichen Geräte und Bedingungen übernommen werden, Temperaturen um 100 °C und kurzfristig bis 120 °C werden ohne Einbuße an Strahlungsempfindlichkeit vertragen.

Zum Belichten können die üblichen Lichtquellen wie Röhrenlampen, Xenonimpulslampen, metallhalogeniddotierte Quecksilberdampf-Hochdrucklampen und Kohlebogenlampen verwendet werden.

Unter Bestrahlung ist in dieser Beschreibung die Einwirkung aktinischer elektromagnetischer Strahlung im Wellenlängenbereich unterhalb etwa 500 nm zu verstehen. Alle in diesem Wellenlängenbereich emittierenden Strahlungsquellen sind prinzipiell geeignet.

Mit Vorteil werden Laserbestrahlungsgeräte, insbesondere automatische Verarbeitungsanlagen verwendet, die als Strahlungsquelle z. B. einen Argon-Ionen-Laser enthalten.

Die Bestrahlung kann auch mit Elektronenstrahlen erfolgen. In diesem Falle können auch im üblichen Sinne nicht lichtempfindliche Säure bildende Verbindungen als Initiatoren der Solubilisierungsreaktion eingesetzt werden, z. B. halogenierte aromatische Verbindungen oder halogenierte polymere Kohlenwasserstoffe. Auch Röntgenstrahlen können zur Bilderzeugung verwendet werden.

Die bildmäßig belichtete oder bestrahlte Schicht kann in bekannter Weise mit praktisch den gleichen Entwicklern wie für handelsübliche Naphthochinondiazid-Schichten und Kopierlacke entfernt werden, oder die neuen Materialien können in ihrem Kopierverhalten mit Vorteil auf die bekannten Hilfsmittel wie Entwickler und programmierte Sprühentwicklungsgeräte abgestimmt werden. Die wäßrigen Entwicklerlösungen können z. B. Alkaliphosphate, -silikate oder -hydroxide und ferner Netzmittel sowie ggf. kleinere Anteile organischer Lösungsmittel enthalten. In bestimmten Fällen sind auch Lösungsmittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Bei der Anwendung als Druckplatten können zur Erhöhung der Widerstandsfähigkeit beim Druck sowie der Resistenz gegen Auswaschmittel, Korrekturmittel und durch UV-Licht härtbare Druckfarben die entwickelten Platten kurze Zeit auf erhöhte Temperaturen erwärmt werden, wie es für Diazoschichten aus der GB-A 1 154 749 bekannt ist.

Die folgenden Beispiele erläutern bevorzugte Ausführungsformen der Erfindung. In den Beispielen stehen Gewichtsteile (Gt) zu Volumenteilen (Vt) im Verhältnis g : $cm^3$; Prozentangaben und Mengenverhältnisse sind, wenn nichts anderes angegeben ist, in Gewichtsanteilen zu verstehen.

Beispiel 1

Auf einseitig drahtgebürstetes Aluminium wird eine Beschichtungslösung aus

| | |
|---|---|
| 7 Gt | eines Kresol-Formaldehyd-Novolaks mit dem Erweichungsbereich 105-120° C nach DIN 53181, |
| 2 Gt | 2-(Naphth-2-yloxy)-5,5-dimethyl-1,3-oxazolin-4-on, |
| 0,4 Gt | 2-(4-Methoxy-anthrac-1-yl)-4,6-bis-trichlormethyl-s-triazin und |
| 0,05 Gt | Säureviolett 596 PINA®, Art.-Nr. 28513, Riedel-de Haen AG in |
| 90,6 Gt | 1-Methoxy-propanol-2 |

mittels Walzenantrag aufgebracht. Es wird ein Schichtgewicht trocken von ca. 2 $g/m^2$ erhalten. Die blauviolette bzw. grün-bläuliche Schicht wird jeweils unter einer positiven Vorlage incl. eines Halbtonstufenkeils belichtet, mit einer 3,5 %igen wäßrigen Lösung von Trinatriumphosphat entwickelt, die durch Zugabe von Natriumhydroxid auf ein pH von 12,6 eingestellt ist, dann mit Wasser abgespült und schließlich durch Überwischen mit 1 %iger Phosphorsäure druckfertig gemacht.

Zum Vergleich wurde eine Druckplatte in gleicher Weise wie zuvor beschrieben hergestellt, wobei jedoch der Farbstoff Säureviolett 596 durch die gleiche Menge Kristallviolettbase ersetzt wurde.

Die mit dem erfindungsgemäß eingesetzten Farbstoff angefärbte Schicht ist ca. 2 Halbtonkeilstufen (= Faktor 2) lichtempfindlicher als die mit Kristallviolett-Base angefärbte. An den belichteten Stellen waren beide Schichten heller gelblich bzw. bläulich. Nach zwei Wochen Liegenlassen belichteter Partien, merklich schon nach 1 Tag, war der Bildkontrast beim Triphenylmethan-Farbstoff verschwunden, beim Hemioxonol-Farbstoff jedoch fast unverändert erhalten.

Beispiel 2

Eine Lösung aus

| | |
|---|---|
| 15 Gt | Butanon, |
| 45 Gt | 1-Methoxy-propan-2-ol, |
| 28 Gt | Novolak wie in Beispiel 1, |
| 3,5 Gt | Polyvinylethylether (Lutonal A 25, BASF), |
| 8,3 Gt | des Polyacetals aus 2-Ethylbutyraldehyd und Triethylenglykol, |
| 0,2 Gt | 2-(6-Methoxy-naphth-2-yl)-4,6-bis-trichlormethyl-s-triazin und |
| 0,2 Gt | Säureviolett 520 PINA®, Antihalofarbstoff von Riedel-de Haen, Art.-Nr. 28587 |

wird hergestellt, um einen Nickelrotationszylinder für den Textilsiebdruck galvanoplastisch zu erzeugen. Auf einem blanken, etwas kontrahierbaren Nickelzylinder, der mit einer leitenden Trennschicht versehen ist, wird durch Sprühbeschichten mittels Druckluft eine ca. 25-30 µm dicke Schicht guter Oberflächenqualität aufgebracht. Der dafür rotierende Zylinder wird anschließend ca. 20 Minuten unter IR-Strahlern ausreichend getrocknet.

Die rotviolette Schicht wird dann unter einem Positiv des zu druckenden Motivs in 32er Raster ausreichend belichtet, wodurch eine fast vollständige Entfärbung zu hellgelb zu einem kontrastreichen Bild erfolgt. Entwickelt wird mit einer Lösung von

| | |
|---|---|
| 0,5 % | NaOH, |
| 0,8 % | Natriummetasilikat × 9 $H_2O$ und |

1,0 % Ethylenglykolmono-n-butylether in
97,7 % vollentsalztem Wasser.

Dazu wird der rotierende belichtete Zylinder in eine mit dem Entwickler halbgefüllte Wanne eingetaucht, nach 4 Minuten Rotieren des Zylinders im Entwickler die Wanne weggezogen, der Zylinder mit Wasser gespült und an der Luft getrocknet.

Auf den freigelegten Stellen des Zylinderkerns wird galvanisch Nickel bis zu einer Dicke von 0,1 mm abgeschieden. Nach Kontrahieren des Zylinderkerns, Ablösen der Resistschablone mit Aceton und Abziehen vom Kern wird eine elastische Rotations-Schablonendruckform erhalten. Durch die Löcher der Rotationsschablone wird Farbe bildmäßig auf Bedruckstoffe übertragen.

Durch den verwendeten Farbstoff wird eine sowohl für die Belichtung als auch die Entwicklung und eventuell Retusche kontrastreichere Schicht erhalten als bisher mit den dazu verwendeten Farbstoffen möglich war. Ahnliche Ergebnisse werden erhalten, wenn anstelle von Säureviolett 520 PINA® das Säureviolett 520 T PINA®, Art.-Nr. 28579, eingesetzt wird.

Beispiel 3

Eine Beschichtungslösung aus
76 Gt 1-Methoxy-propan-2,
13,6 Gt Novolak,
6,6 Gt 1,3-Bis-[2-(5-ethyl-5-butyl-1,3-dioxacyclohexoxy)]-2-ethyl-2-butyl-propan,
1,1 Gt 2-Acenaphth-5-yl-4,6-bis-trichlormethyl-s-triazin und
0,1 Gt des Polymethinfarbstoffs Sensibilisator S 935 PINA®, Art.-Nr. 28246
wird benutzt, um Silicium-Wafer durch Aufschleudern mit 6000 Upm und Nachtrocknen im Umluftschrank mit einer angefärbten lagerfähigen Positivschicht hoher Lichtempfindlichkeit zu versehen. Beim Belichten tritt ein deutlicher Bildkontrast von lila nach hellrot auf, wie er in den in der Mikroelektronik viel verwendeten handelsüblichen Photoresists, z. B. AZ 1350 J auf Basis von o-Chinondiaziden nicht erreicht wird.

Beispiel 4

Die Eignung der genannten Farbstoffe in elektronenstrahlenempfindlichen Schichten wird im folgenden gezeigt. Eine Fotoresistlösung wird hergestellt aus
55 Gt eines Copolymeren aus 4-Hydroxy-styrol und Hexylmethacrylat (OH-Zahl 290; RSV-Wert 0,55 dl/g in Dimethylformamid),
15 Gt des Polyacetals aus Diethylenglykoldivinylether und Cyclohexan-1,4-diol,
0,5 Gt 2-(4-Ethoxy-naphth-1-yl)-4,6-bis-trichlormethyl-s-triazin,
0,2 Gt Säurerot 496 PINA®, Art.-Nr. 28591,
0,2 Gt CI Solvent Blue 35, (CI 61554),
170 Gt Ethanol.

Mit dieser Lösung wird durch Schleuderbeschichten bei 125 Upm eine mit Indium-Zinn-Oxid (ITO) beschichtete Glasplatte für die Herstellung von Flüssigkristall-Anzeigeelementen (LC-Displays) ca. 12 µm (ca. 15 g/cm$^2$ dick lackiert. Die hellblaue Schicht wird so mit 11 kV-Elektronen bestrahlt, daß dort die Farbe fast völlig verschwindet und nur die späteren Leiterbahnen schon gut sichtbar sind. Dies kontrastreiche Bild wird nach ca. 40 s für 10 cm$^2$ bei einem Strahlstrom von 5 µA erreicht und mit einem gepufferten, Netzmittel enthaltenden wäßrig-alkalischen Entwickler von pH 13,2 entwickelt. Nach Ätzen des ITO an den freigelegten Stellen mit 5 %iger Salzsäure und Strippen des Resists ist die Platte z. B. für eine 7-Segment-Ziffernanzeige fertig. Der Bildkontrast wird durch die Grundeinfärbung mit Solvent Blue 35 verstärkt.

Beispiel 5

Zur Herstellung von Feinleiterplatten im Walzenantrag (roller coater) werden die folgenden Schichtbestandteile
64 Gt Novolak,
10,5 Gt Polyvinylmethylether (Lutonal M 40),
15 Gt Polyacetal aus 2-Ethylbutyraldehyd und Hexan-1,6-diol,
9,8 Gt des Polyorthoesters aus Trimethoxymethan und 5-Oxa-7,7-di-hydroxymethyl-nonan-1-ol,
0,4 Gt 2-4-(2-Ethoxyethoxy)-naphth-1-yl-4,6-bis-trichlormethyl-s-triazin und
0,3 Gt Säureviolett 520 A PINA®, Art.-Nr. 28582
in 1-Methoxy-2-propan-2-ol zu einer Lösung von 30 % Feststoffgehalt gelöst. Man erhält eine Beschichtungslösung einer Viskosität von etwa 90 $mm^2/s$, geeignet für Walzenantrag, z. B. mit dem Walzenantragsgerät AKL 400 der Fa. Bürkle, Freudenstadt. Mit Gummi-Riffelwalzen mit 48 Rillen je 2,5 cm (linear) kann man durch einmaligen Antrag beidseitig Trockenschichtdicken bis ca. 10 µm erhalten auf durchkontaktierten kupferkaschierten Isolierstoffplatten, ohne die Löcher zu füllen.

Nach dem Trocknen wird die Platte zunächst unter einer negativen Vorlage, die den Lochbereichen entspricht, belichtet, dann werden mit dem in Beispiel 2 angegebenen Entwickler diese Bereiche ausgewaschen. Die Platte wird 10 Minuten bei 80° C getrocknet, dann an den freigelegten Lochbereichen galvanisch mit Kupfer verstärkt, wonach galvanisch Blei/Zinn abgeschieden wird. Danach wird diese Photoresistschicht unter einer positiven Leiterbahnvorlage belichtet und wie oben entwickelt. Das freigelegte Kupfer wird mit einem alkalischen Ätzmittel weggeätzt, wobei Feinleiterzüge mit ca. 70 µm Kupferbahnbreite entstehen.

Durch den anstelle von Kristallviolett-Base verwendeten Farbstoff wird ein nicht nur beim ersten Belichtungsschritt, sondern auch noch nach dem Galvanisieren bei der Zweitbelichtung sowohl zu den unbelichteten Partien als auch zu den galvanisierten Stellen sehr kontrastreiches Bild bei vergleichsweise hoher Lichtempfindlichkeit erzeugt. Durch den hohen Bildkontrast können sowohl evtl. Passerfehler dieser Feinleiterschaltung als auch nötige Retuschearbeiten gut kontrolliert und erledigt werden. Ähnliche Ergebnisse werden erhalten, wenn anstelle von Säureviolett 520 A der Sensibilisator KF 605, Art.-Nr. 28590 verwendet wird, wobei der Bildkontrast von grün nach hell geht.

Beispiel 6

Eine Beschichtungslösung aus

| | |
|---|---|
| 8,0 Gt. | eines Copolymeren aus 4-Isopropenylphenol und Methylmethacrylat (OH-Zahl 310; RSV-Wert 0,189 dl/g in Dimethylformamid), |
| 0,8 Gt. | eines polymeren Orthoesters, hergestellt durch Kondensation von Orthoameisensäuretrimethylester mit 4-Oxa-6,6-bis-hydroxymethyl-octan-1-ol, |
| 0,03 Gt. | 2-(4-Styrylphenyl)-4,6-bis-trichlormethyl-s-triazin, |
| 0,01 Gt. | Säureviolett 520 N PINA®, Art.-Nr. 28500 und zur Grundeinfärbung, |
| 0,01 Gt. | des Sensibilisators KF 509 PINA®, Art.-Nr. 28297 in |
| 180 Gt | Methylethylketon |

wird auf einen mit Metalldrahtbürsten aufgerauhten Aluminiumträger aufgebracht und getrocknet. Die erhaltene lichtempfindliche Platte hat ein Schichtgewicht von ca. 1,5 $g/m^2$. Sie wird unter einer 5 kW-Metallhalogenid-Lampe im Abstand von 140 cm 5 s mit einer positiven Vorlage belichtet und in ca. 30 s mit einer Lösung aus

| | |
|---|---|
| 0,6 % | NaOH |
| 0,5 % | Natriummetasilikat × 5 $H_2O$ und |
| 1,0 % | n-Butanol in |
| 97,9 % | vollentsalztem Wasser entwickelt. |

Die unbestrahlten Bereiche lassen sich mit fetter Farbe zum Drucken in einer Offsetdruckmaschine einfärben. Diese hochlichtempfindliche Positivoffsetplatte zeigt sowohl hervorragenden Bildkontrast nach der Belichtung als auch bei der Entwicklung und erleichtert durch diese Einfärbung die Verarbeitungskontrolle.

Beispiel 7

Zur Herstellung eines Positiv-Trockenresists für Ätz-und Galvano-Anwendungen wurde die folgende Lösung hergestellt:

| | |
|---|---|
| 57 Gt | Methylethylketon, |
| 30 Gt | Novolak wie in Beispiel 1, |
| 7,5 Gt | Bis-(5-ethyl-5-methoxymethyl-1,3-dioxan-2-yl)-ether von 2-Ethyl-2-methoxymethyl-1,3-propandiol, |
| 5,0 Gt | 1,3-Propandiol-bis-(3,4-dihydro-naphth-2-yl)ether, |
| 0,3 Gt | des in Beispiel 5 angegebenen Triazins, |
| 0,2 Gt | Säureviolett 520 T PINA®, Art.-Nr. 28579. |

Damit wurde eine biaxial verstreckte und thermofixierte 25 µm dicke Folie aus Polyethylenterephthalat, die mit Trichloressigsäure/Polyvinylalkohol vorbehandelt worden war, so beschichtet, getrocknet und mit einer 12 µm dicken Polyethylenfolie kaschiert, daß eine gleichmäßig 15 µm dicke Resistschicht zwischen den beiden Folien entstand.

In einem handelsüblichen Laminator wurden nach Abziehen der Deckfolie blanke Messingplatten zur

Herstellung von Kontaktfedern für Schalter beidseitig mit dieser Schicht unter Druck und Wärme laminiert. Nach Abkühlen, Abziehen der Trägerfolie und kurzem Nachtrocknen im Trockenschrank (80° C) wurde mit einem deckungsgleichen Vorlagenpaar in Form einer Tasche das beschichtete Werkzeug beidseitig belichtet, wobei der Bildfärbung von lilarot nach hellgelb umschlug. Anschließend wurde mit dem in Beispiel 2 genannten Entwickler beidseitig sprühentwickelt, gespült, und die kontrastreichen Platten wurden mit handelsüblicher Ferrichlorid-Lösung im Formteilätzverfahren solange geätzt, bis sie zu glatten Flanken durchgeätzt waren.

Die so im Nutzen hergestellten Formätzteile wurden vor dem Vereinzeln zum Freilegen und Vergolden der Kontaktenden mit der entsprechenden Vorlage zweitbelichtet. Die Resistschicht zeigte wiederum ein kontrastreiches Bild; sie wurde dann entwickelt und schließlich an den freigelegten Stellen dünn galvanisch vergoldet. Erst nach der wegen des auch guten Kontrastes zwischen Goldschicht und verbliebener roter Resistschicht auf Messing leichten Endkontrolle wurden diese Schalterteile vom Resist gestrippt, in die richtige Form gebogen und eingebaut.

**Patentansprüche**

**1.** Positiv arbeitendes strahlungsempfindliches Gemisch, das als wesentliche Bestandteile
a) eine strahlungsempfindliche Verbindung, die bei Einwirkung von aktinischer Strahlung eine starke Säure bildet,
b) eine Verbindung mit mindestens einer durch Säure spaltbaren C-O-C-Bindung,
c) ein in Wasser unlösliches, in wäßrig-alkalischen Lösungen aber lösliches Bindemittel und
d) einen Polymethinfarbstoff
enthält, dadurch gekennzeichnet, daß der Polymethinfarbstoff ein Hemioxonol- oder ein symmetrischer Cyaninfarbstoff ist.

**2.** Strahlungsempfindliches Gemisch nach Anspruch 1, dadurch gekennzeichnet, daß es einen Hemioxonolfarbstoff der Formel I enthält:

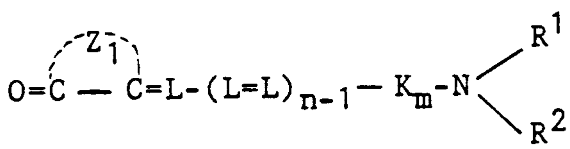

(I)

worin

| | |
|---|---|
| L | eine Methingruppe, die unsubstituiert oder durch eine Alkylgruppe substituiert ist, |
| K | ein carbokonjugiertes Ringsystem, |
| n | eine positive Zahl von 1 bis 3, |
| m | 0 oder 1 ist, |
| $R^1$ und $R^2$ | gleich oder verschieden sind und Wasserstoffatome oder Alkylreste bedeuten und |
| $Z_1$ | nichtmetallische Atome bedeutet, die einen fünf- oder sechsgliedrigen heterocyclischen Ring komplettieren, der auch substituiert sein kann. |

**3.** Strahlungsempfindliches Gemisch nach Anspruch 1, dadurch gekennzeichnet, daß es einen symmetrischen Cyaninfarbstoff der Formel II enthält:

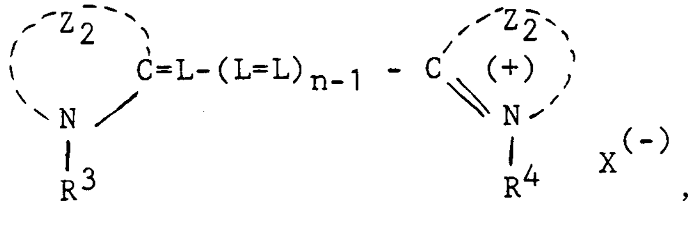

(II)

worin bedeuten:

| | |
|---|---|
| L | eine Methingruppe, die unsubstituiert oder durch eine Alkylgruppe substituiert ist, |

n eine positive ganze Zahl von 1 bis 4,
$R^3$ und $R^4$ jeweils einen Alkylrest,
$Z_2$ die zur Vervollständigung eines substituierten oder unsubstituierten heterocyclischen Ringsystems erforderlichen Atome und
$X^{(-)}$ ein Anion.

**4.** Strahlungsempfindliches Gemisch nach Anspruch 2, dadurch gekennzeichnet, daß das lineare carbokonjugierte System des Hemioxonolfarbstoffs entweder in meso-Stellung durch eine Alkylgruppe substituiert oder durch einen carbocyclischen Ring erweitert ist und $Z_1$ einen Pyrazolinonring bedeutet.

**5.** Strahlungsempfindliches Gemisch nach Anspruch 3, dadurch gekennzeichnet, daß $R^3$ und $R^4$ gleich sind und für Ethylgruppen stehen, $Z_2$ jeweils mindestens zwei annellierte Ringe bedeutet und $X^{(-)}$ für ein Bromid-Ion steht.

**6.** Strahlungsempfindliches Gemisch nach Anspruch 1, dadurch gekennzeichnet, daß der Gehalt an Polymethinfarbstoff im strahlungsempfindlichen Gemisch bei 0,05 bis 1,0 Gew.-% liegt.

**7.** Strahlungsempfindliches Gemisch nach Anspruch 1, dadurch gekennzeichnet, daß das in Wasser unlösliche, in wäßrig-alkalischen Lösungen aber lösliche Bindemittel ein Novolak, ein Polyvinylphenol oder ein Copolymeres aus Acryl- oder Methacrylsäure und einem Acrylat oder Methacrylat ist.

**8.** Strahlungsempfindliches Gemisch nach Anspruch 1, dadurch gekennzeichnet, daß die Verbindung, die bei Einwirkung von aktinischer Strahlung eine starke Säure bildet, ein Trihalogenmethyl-s-triazin ist

**9.** Strahlungsempfindliches Gemisch nach Anspruch 1, dadurch gekennzeichnet, daß die säurespaltbare Verbindung ein Orthocarbonsäurederivat oder ein Acetal ist.

**10.** Verfahren zur herstellung von Fotoresists und Druckplatten, dadurch gekennzeichnet, daß ein strahlungsempfindliches Gemisch nach Anspruch 1 auf einen Träger aufgebracht, die Schicht getrocknet, unter Einwirkung von aktinischer Strahlung bildmäßig bestrahlt, entwickelt und der Schichtträger an den freigelegten Stellen durch Ätzen oder Metallabscheidung modifiziert wird.

**11.** Verfahren nach Anspruch 10, dadurch gekennzeichnet, daß die Restschicht nach der Modifizierung des Schichtträgers unter einer weiteren Vorlage belichtet und entwickelt und der dabei freigelegte Schichtträger wiederum modifiziert wird.

## Claims

**1.** A positive-working radiation-sensitive mixture containing, as the essential constituents,
a) a radiation-sensitive compound which forms a strong acid under the action of actinic radiation,
b) a compound with at least one C-O-C bond cleavable by acid,
c) a binder which is insoluble in water but soluble in aqueous-alkaline solutions and
d) a polymethine dye,
wherein the polymethine dye is a hemioxonol dye or a symmetrical cyanine dye.

**2.** A radiation-sensitive mixture as claimed in claim 1, which contains a hemioxonol dye of the formula I:

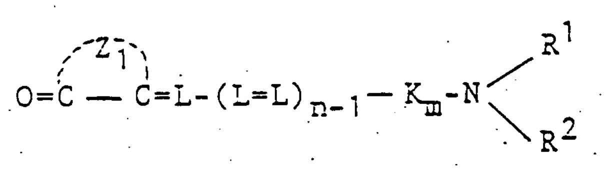

(I)

in which
L is a methine group which is unsubstituted or substituted by an alkyl group,
K is a carbon-conjugated ring system,
n is a positive number from 1 to 3,

m is 0 or 1,
$R^1$ and $R^2$ are identical or different and represent hydrogen atoms or alkyl radicals, and
$Z_1$ represents non-metallic atoms which complete a five-membered or six-membered heterocyclic ring which can also be substituted.

**3.** A radiation-sensitive mixture as claimed in claim 1, which contains a symmetrical cyanine dye of the formula II:

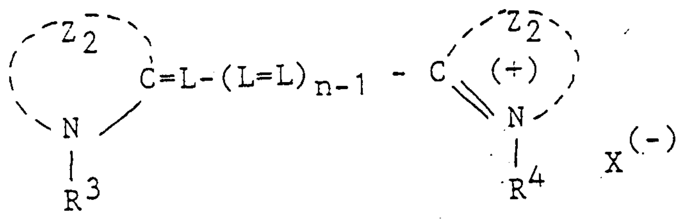

(II)

in which
L is a methine group which is unsubstituted or substituted by an alkyl group,
n is a positive integer from 1 to 4,
$R^3$ and $R^4$ are each an alkyl radical,
$Z_2$ represents the atoms required for completing a substituted or unsubstituted heterocyclic ring system, and
$X^{(-)}$ is an anion.

**4.** A radiation-sensitive mixture as claimed in claim 2, wherein the linear carbon-conjugated system of the hemioxonol dye is either substituted in the meso-position by an alkyl group or is enlarged by a carbocyclic ring, and $Z_1$ is a pyrazolinone ring.

**5.** A radiation-sensitive mixture as claimed in claim 3, wherein $R^3$ and $R^4$ are identical and represent ethyl groups, each $Z_2$ represents at least two fused rings and $X^{(-)}$ is a bromide ion.

**6.** A radiation-sensitive mixture as claimed in claim 1, wherein the polymethine dye content in the radiation-sensitive mixture is 0.05 to 1.0% by weight.

**7.** A radiation-sensitive mixture as claimed in claim 1, wherein the binder, which is insoluble in water but soluble in aqueous-alkaline solutions, is a novolak, a polyvinylphenol or a copolymer of acrylic or methacrylic acid and an acrylate or methacrylate.

**8.** A radiation-sensitive mixture as claimed in claim 1, wherein the compound which forms a strong acid under the action of actinic radiation is a trihalogenomethyl-s-triazine.

**9.** A radiation-sensitive mixture as claimed in claim 1, wherein the compound cleavable by acid is an orthocarboxylic acid derivative or an acetal.

**10.** A process for the preparation of photoresists and printing plates, which comprises applying a radiation-sensitive mixture as claimed in claim 1 to a support, drying the layer, irradiating imagewise under the action of actinic radiation, developing and modifying the layer support in the bared areas by etching or metal deposition.

**11.** The process as claimed in claim 10, which comprises, after the modification of the layer support, exposing the residual layer under a further original, developing and again modifying the layer support thus bared.

## Revendications

**1.** Composition sensible aux radiations, travaillant en positif, contenant en tant que composants essentiels
a) un compose sensible aux radiations, qui forme un acide fort sous l'effet d'un rayonnement

actinique,
b) un composé comportant au moins une liaison C-O-C sécable par un acide,
c) un liant insoluble dans l'eau, mais soluble dans des solutions aqueuses-alcalines, et
d) un colorant polyméthine,

caractérisée en ce que le colorant polyméthine est un colorant hémioxonol ou un colorant cyanine symétrique.

**2.** Composition sensible aux radiations selon la revendication 1, caractérisée en ce qu'elle contient un colorant hémioxonol de formule I:

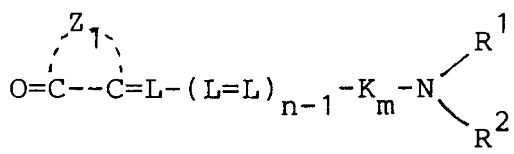

(I)

dans laquelle

| | |
|---|---|
| L | est un groupe méthine qui n'est pas substitué ou est substitué par un groupe alkyle, |
| K | est un système cyclique carboconjugué, |
| n | est un nombre positif allant de 1 à 3, |
| m | est 0 ou 1, |
| $R^1$ et $R^2$ | sont identiques ou différents, et représentent des atomes d'hydrogène ou des radicaux alkyle, et |
| $Z_1$ | représente des atomes non métalliques qui complètent un cycle hétérocyclique à 5 ou 6 chaînons, qui peut également être substitué. |

**3.** Composition sensible aux radiations selon la revendication 1, caractérisée en ce qu'elle contient un colorant cyanine symétrique de formule II:

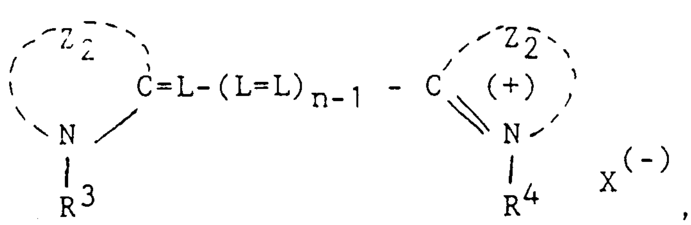

(II)

dans laquelle

| | |
|---|---|
| L | représente un groupe méthine qui n'est pas substitué ou est substitué par un groupe alkyle, |
| n | représente un nombre entier positif allant de 1 à 4, |
| $R^3$ et $R^4$ | représentent chacun un radical alkyle, |
| $Z_2$ | représente les atomes requis pour compléter un système cyclique hétérocyclique substitué ou non substitué, et |
| $X^{(-)}$ | représente un anion. |

**4.** Composition sensible aux radiations selon la revendication 2, caractérisée en ce que le système carboconjugué linéaire du colorant hémioxonol soit est substitué en position méso par un groupe alkyle, soit est agrandi par un cycle carbocyclique, et $Z_1$ représente un cycle pyrazolinone.

**5.** Composition sensible aux radiations selon la revendication 3, caractérisée en ce que $R^3$ et $R^4$ sont identiques et représentent des groupes éthyle, $Z_2$ représente dans chaque cas au moins deux cycles condensés et $X^{(-)}$ représente l'ion bromure.

**6.** Composition sensible aux radiations selon la revendication 1, caractérisée en ce que la teneur en colorant polyméthine de la composition sensible aux radiations va de 0,05 à 1,0 % en poids.

7. Composition sensible aux radiations selon la revendication 1, caractérisée en ce que le liant insoluble dans l'eau, mais soluble dans des solutions aqueuses-alcalines, est une Novolaque, un polyvinylphénol ou un copolymère d'acide acrylique ou méthacrylique et d'un acrylate ou méthacrylate.

8. Composition sensible aux radiations selon la revendication 1, caractérisée en ce que le composé qui forme un acide fort sous l'effet d'un rayonnement actinique est une trihalogénométhyltriazine s.

9. Composition sensible aux radiations selon la revendication 1, caractérisée en ce que le composé dissociable par un acide est un dérivé d'acide orthocarboxylique ou un acétal.

10. Procédé pour la fabrication de photoresists et de plaques d'impression, caractérisé en ce que l'on applique sur un support une composition sensible aux radiations selon la revendication 1, on sèche la couche, on l'irradie selon l'image sous l'effet d'un rayonnement actinique, on la développe et on modifie le support de couche, dans les zones mises à nu, par attaque chimique ou dépôt de métal.

11. Procédé selon la revendication 10, caractérisé en ce que la couche résiduelle après la modification du support de couche est insolée sous un autre original et développée, et le support de couche ainsi mis à nu est modifié à nouveau.